# EUROPEAN PATENT SPECIFICATION

(11) **EP 0 863 496 B1**
(45) Date of publication and mention of the grant of the patent: **09.10.2002**
(21) Application number: 98830113.1
(22) Date of filing: 04.03.1998
(51) Int. Cl.: G09F 9/33, H05K 7/20

(54) **Container for led luminous billboard**
Gehäuse für LED-Anzeigeplakat
Boîtier pour afficheur lumineux à LED

(30) Priority: 05.03.1997 IT BA970012
(43) Date of publication of application: 09.09.1998
(73) Proprietor: Ciesse Sistemi Srl, 70011 Alberobello (BA) (IT)
(72) Inventor: Convertino, Giorgio, 70011 Alberobello (BA) (IT)

(56) References cited:
- PATENT ABSTRACTS OF JAPAN vol. 098, no. 007, 31 March 1998 & JP 01 088578 A (MATSUSHITA ELECTRIC IND CO LTD), 3 April 1989
- PATENT ABSTRACTS OF JAPAN vol. 096, no. 006, 28 June 1996 & JP 08 050458 A (SEIWA DENKI KK), 20 February 1996

## Description

The container for led luminous billboard, named also "LED-board container", by Ciesse Sistemi from Alberobello (Italy) derives from the need to solve some problems connected with the construction of large electronic boards for outside use, in every weather condition, or inside, before lights.

So, we thought to create a "container" or module, equipped with fins (fig. 3.3) which shelter from the sunlight through the contrast with the black bottom given by the obscuration of the same ones.

The container is made up of a board provided with some holes where LEDS (light emitter such as small lamps or bulbs) are slotted. Upon each row of LEDS there is an aluminium transverse strip, named "fin" (fig. 3.3), attached directly on the "container's" body (fig. 3.5).

Moreover, the fins (fig. 3.3) do not allow smog and dusts deposits upon the LEDS' front side, deposits which can damage both the LEDS structure material and the internal part made up of electronic boards.

The "LED-board container" is also made up of holes which allow the complete LEDS cooling directly on the whole aluminium body (fig. 3.5) thereby becoming a perfect heat exchanger, and allowing the removal of the old fan cooling systems, so as to cut down the electric consumption from 10 to 30%.

Such a structure, in aluminium, made up of holes and transverse fins, renders the container (or module) anti-vandal and anti-breaking, and allows the elimination of methacrylate, polycarbonate and glass materials, etc

The "LED-board container" is structured in such a way to allow even the installation of large boards without the employment of lifting machines, through the "tiling" mode.

This allows also a simpler system for repair interventions, with the possibility to intervene on the single container rather than on the entire electronic board.

### USE

The outdoor use for the making of large electronic LED-boards which can be assembled with various containers, for the display of informative and advertising messages in colour animated computer graphics; giant videos for outside television broadcasting and inside before lights.

### STATE OF THE TECHNIQUE AT THE DEPOSIT MOMENT

### ST.1

At the moment people normally use steel containers or aluminium with methacrylate or polycarbonate or front lenses.

Containers with vents for air circulation, or electronic boards with air conditioner cooling system.

Today people realize containers with disadvantages indicated at item ST.1, with frames on the four sides which do not allow the modules pitch flanking and overlap and leave a gap between them which is not illuminated.

### ADVANTAGES

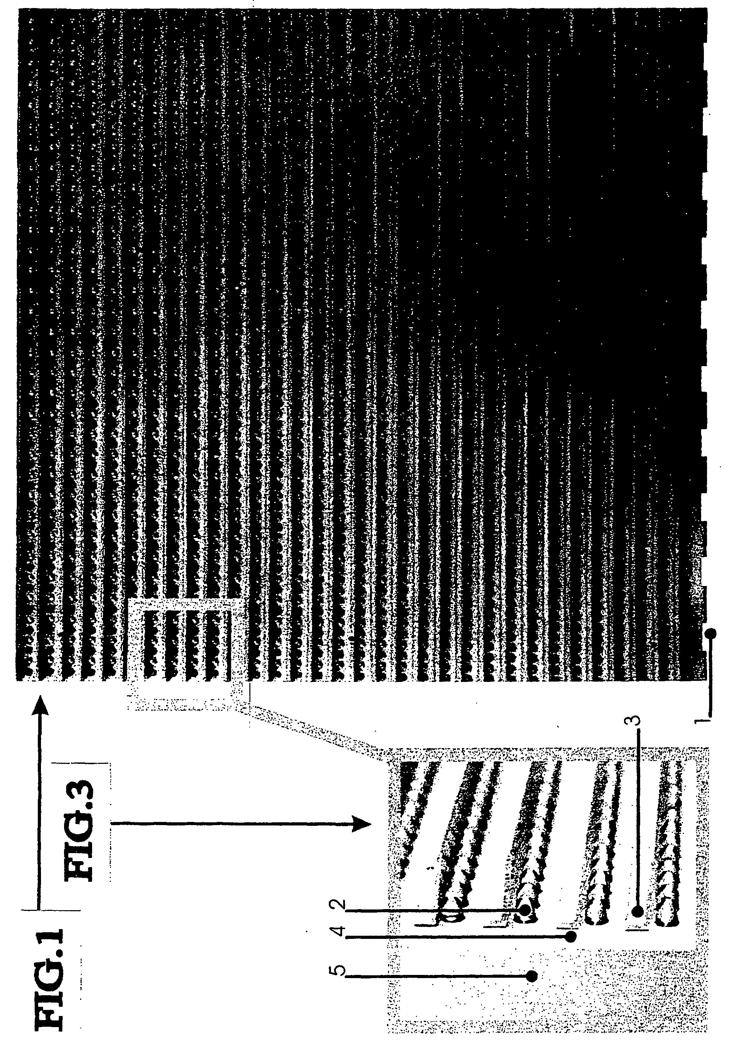

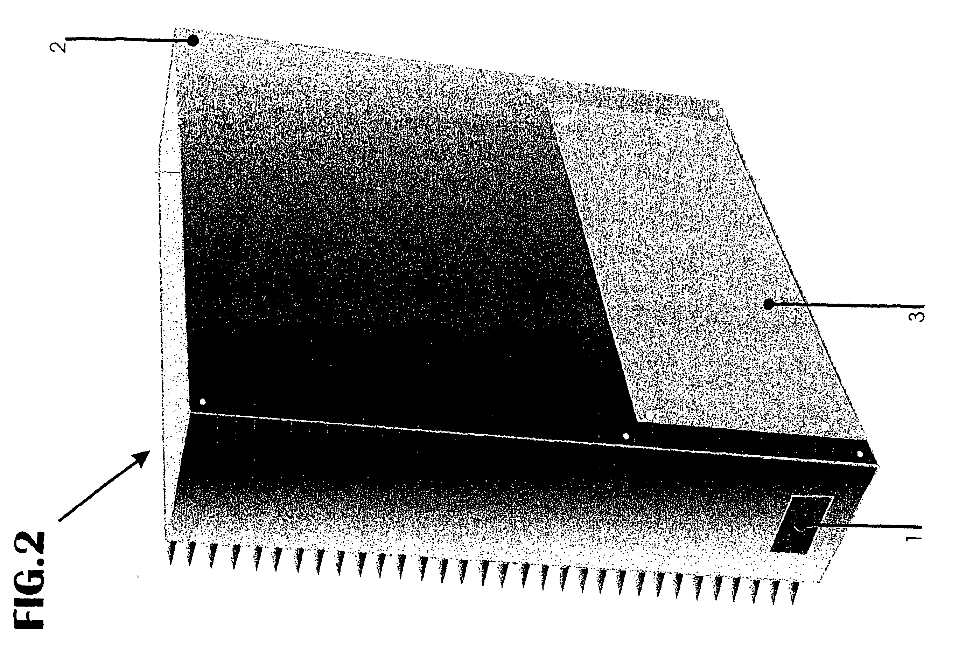

The "LED-board container" has the following advantages:
1. LEDS protection:
   LEDS protection from the sunlight through fins (fig. 3.3) allows them to last ten times more than the standard durability.
2. Ultraviolet rays protection:
   LEDS which are not hit by ultraviolet rays preserve their structural material intact.
3. Antismog:
   The fin (fig. 3.3) does not allow smog deposits on the front side of the LEDS which maintain all their transparency for a complete light emission.
4. Visibility against the sun:
   The contrast with the black bottom given by the fins obscuration allows a perfect visibility of the LEDS light emission and of the messages even against the sun.
5. Direct cooling:
   The "LED-board container" by means of the LED direct and circumscribed contact through the hole (fig. 3.2), allows the complete cooling of each LED directly upon all the aluminium body and becomes a perfect heat exchanger.
6. Fans removal:
   The components cooling, directly upon the finned aluminium body, offers the advantage of removing the old fan cooling systems.
7. Air intakes removal:
   Air intakes removal connected with the fins' presence does not favour the introduction of dusts and smog which can settle on the electronic components, thus reducing to a minimum the damages and unsteady contacts risks.
8. Anti-vandal and anti-breaking system:
   The structure designed with direct drilling system upon the container's body for light emission and transverse fins' installation, makes the module anti-vandal and anti-braking.
9. Methacrylate's removal:
   The use of "LED-board container" (fig. 1) allows the removal of the standard material in methacrylate, polycarbonate, glass, etc, which if provided with a glossy surface give the reflection, on the contrary if provided with a dull surface they become a protection which darken the LEDS' light emission
10. Weatherproof system and rain protection:
   The cover-configuration of the "LED-board container's" structure allows it to be completely rainproof and to adopt the weatherproof features.
11. Transport's easiness:
   The small size structure of the "LED-board container" allows also an easy transport even of large boards without size limits.
12. Easiness of assembly:
   The installation of a big billboard can be executed without using cranes for the lifting, as the considerable lightnessof the container allows the assembly with hands like "tiled".
13. Elimination of interspaces:
   The container do not include any frames on four side (p.3.4). This allows to put beside and to place on the containers so that all the leds are composed with the same pitch.
14. Easiness of repair interventions:
   A large electronic board, made up of various " LED-board containers" can be repaired through interventions on single damaged containers.
15. Reduction of costs for electronic boards' construction:
   The possibility of direct cooling of electronic components, allows the removal of costs for the installation of traditional air conditioners used for motorway boards or for other functions.
16. Reduction of electric consumption:
   The removal of air conditioners or fan absorption allows the electronic boards to reduce the electric consumption from 10 to 30%.
17. System without seals:
   The "LED-board container" is designed so as not to need any seal even for the inspection's cap.

## Claims

1. A LED-board container comprising a front panel provided with fins on its outer surface which are designed for protection of the LEDs against sun, bad weather and dust **characterised in that** the front panel is made of aluminium and the LEDs are disposed in holes formed in said front panel which have the size of the LEDs to effect direct cooling of the LEDs and cooling of the LED-board container's internal components by heat conduction via said aluminium front panel.

2. A container according to claim 1, formed by walls unprovided with air intakes.

3. A container according to claim 1, formed by walls which is able to work non-stop without any type of air conditioning for cooling.

4. A container according to claim 1, wherein said holes are in the form of drillings for insertion of LEDs.

5. A container according to claim 4, which has fins between one row of LEDs and another in order to disperse sunshine.

6. A container according to claim 4, which has threaded inserts on the four corners of its back surface.

7. A container according to claim 4, devoid of frames so as to allow placing side by side one container to another without having gaps between them so that all the LEDs are composed with the same pitch.

8. A container according to claim 1, able to work singularly or together with other containers, even in an independent way one from the other.

9. A container according to claim 1, being weatherproof but without seals.

## Patentansprüche

1. Ein LED-Paneel-Behälter, der mit einem Frontpaneel ausgestattet ist, das Abdeckklappen auf der Außenseite besitzt, welche die LEDs gegen Sonnenlicht, Schlechtwetter und Staub schützen. Das Frontpaneel ist aus Aluminium und die LEDs sind auf diesem in Löchern angebracht, welche der LED-Größe entsprechen, so dass eine direkte Kühlung der LEDs sowie der inneren Komponenten des LED-Paneel-Behälters mittels Wärmeleitung durch das genannte Aluminium-Front-Paneel erfolgt.

2. Ein den Anspruch von Punkt 1 entsprechender Behälter, der Seitenteile ohne Luftzufuhrschlitze besitzt.

3. Ein den Anspruch von Punkt 1 entsprechender Behälter mit Seitenteilen, welcher in der Lage ist, ohne jegliche Art von Luftaufbereitung zur Kühlung durchgehend in Betrieb zu sein.

4. Ein den Anspruch von Punkt 1 entsprechender Behälter, auf welchem besagte Löcher in Form von Bohrlöchern für die Anbringung der LEDs ausgeführt sind.

5. Ein den Anspruch von Punkt 4 entsprechender Behälter, welcher Abdeckklappen zwischen den einzelnen LEDs-Reihen zum Schutz gegen Sonnenbestrahlung besitzt.

6. Ein den Anspruch von Punkt 4 entsprechender Behälter, der Einsatzteile mit Gewinde an den 4 Ecken auf der Rückseite besitzt.

7. Ein den Anspruch von Punkt 4 entsprechender Behälter ohne Rahmenstruktur, sodass ein Behälter neben einem anderen platziert werden kann, ohne dass Zwischenräume entstehen und alle LEDs im gleichen Abstand angeordnet sind.

8. Ein den Anspruch von Punkt 1 entsprechender Behälter, welcher allein oder zusammen mit anderen Behältern betriebsfähig ist, sogar völlig unabhängig voneinander.

9. Ein den Anspruch von Punkt 1 entsprechender Behälter, der wasserfest ist jedoch keine Dichtung besitzt.

## Revendications

1. Un conteneur pour un panneau avec indicateurs LED qui comprend un panneau frontal équipé d'ailettes sur la surface externe conçues pour protéger les indicateurs LED de la lumière solaire, des mauvaises conditions atmosphériques et de la poussière; possédant la caractéristique que le panneau frontal soit en aluminium et que les indicateurs LED soient disposés dans des trous placés dans ce panneau frontal et ayant les dimensions des indicateurs LED, de façon à obtenir un refroidissement direct de ces indicateurs et le refroidissement des composants internes du conteneur du panneau avec les indicateurs LED grâce à la conduction thermique, c'est-à-dire au moyen de ce panneau frontal en aluminium.

2. Un conteneur conforme à la revendication 1, ayant des parois qui ne soient pas munies de prises d'air.

3. Un conteneur conforme à la revendication 1, ayant des parois et en mesure de fonctionner de façon continue sans aucun type de conditionnement de l'air pour le refroidissement.

4. Un conteneur conforme à la revendication 1, dans lequel les trous indiqués sont sous forme de perforations pour l'insertion des indicateurs LED.

5. Un conteneur conforme à la revendication 4 et muni d'ailettes entre une file de LED et l'autre de façon à disperser la lumière solaire.

6. Un conteneur conforme à la revendication 4 qui possède des éléments filetés sur les quatre angles de la surface postérieure.

7. Un conteneur conforme à la revendication 4, sans structure à cadre afin de permettre que les conteneurs soient l'un à côté de l'autre sans qu'il y ait d'espace entre eux, de façon à ce que tous les indicateurs LED soient placés à la même distance.

8. Un conteneur conforme à la revendication 1, en mesure de fonctionner tout seul ou ensemble avec les autres conteneurs, mais de toutes façons indépendamment des autres.

9. Un conteneur conforme à la revendication 1, qui est étanche mais sans joints d'étanchéité.
